# EUROPÄISCHE PATENTSCHRIFT

(11) **EP 2 318 724 B1**
(45) Veröffentlichungstag und Bekanntmachung des Hinweises auf die Patenterteilung: **21.06.2017**
(21) Anmeldenummer: 09780360.5
(22) Anmeldetag: 09.07.2009
(51) Int. Cl.: F16B 21/09, B60R 11/00, B62D 27/00, H05K 7/12

(54) **BEFESTIGUNGSVORRICHTUNG UND VERFAHREN ZUM BEFESTIGEN EINES ELEMENTES IN EINEM SCHLÜSSELLOCHFÖRMIGEN AUSSCHNITT EINER WAND**
MOUNTING DEVICE AND PROCEDURE FOR FASTENING AN ELEMENT IN A KEYHOLE CUTOUT OF A WALL
DISPOSITIF ET PROCÉDURE DE FIXATION D'UN ÉLÉMENT DANS UNE OUVERTURE EN TROU DE SERRURE D'UNE PAROI

(30) Priorität: 27.08.2008 DE 102008041613
(43) Veröffentlichungstag der Anmeldung: 11.05.2011
(73) Patentinhaber: Robert Bosch GmbH, 70442 Stuttgart (DE)
(72) Erfinder: VARGHA, David, H-1192 Budapest (HU); ADAM, Boris, 71126 Gaeufelden (DE); BEHNKE, Ulf, 72764 Reutlingen (DE); WEGNER, Jeanine, 72793 Pfullingen (DE)
(86) Internationale Anmeldenummer: PCT/EP2009/058728
(87) Internationale Veröffentlichungsnummer: WO 2010/023020

(56) Entgegenhaltungen:
- WO-A1-2004/020844
- DE-A1-102005 002 021
- US-B1- 6 222 123

## Beschreibung

Die vorliegende Erfindung betrifft eine Befestigungsvorrichtung zur Befestigung eines Elementes in einem schlüssellochförmigen Ausschnitt einer Wand gemäß Anspruch 1 sowie ein Verfahren zum Befestigen einer Befestigungsvorrichtung an einer Wand gemäß Anspruch 8.

### Stand der Technik

Bauteile, insbesondere Sensoren (z.B. für Rückhaltesysteme) werden in der Automobilindustrie auf unterschiedliche Weise am Fahrzeug befestigt. Neben Anschrauben an eine in der Karosserie eingeschweißte Mutter oder Anschrauben mittels einer Schraube durch ein Loch in der Karosserie in eine Gewindebuchse des Bauteils wird das "Schlüssellochprinzip" zur Befestigung von Gehäusen verwendet. Hierbei wird z.B. ein im Gehäuse vormontierter Bolzen mit einer selbstsichernden Mutter in den größeren Teil eines schlüssellochartigen Lochs in dem Karosserieblech des Fahrzeugs eingeführt und dann im unteren schmäleren Teil des Schlüssellochs eingehängt. Danach wird die Mutter angezogen und das Bauteil dadurch festgeklemmt.

Das Schlüssellochprinzip hat gegenüber den beiden anderen oben erwähnten Methoden den Vorteil, dass keine eingeschweißte und keine vormontierte Mutter im Fahrzeug notwendig ist, was einen erheblichen Kostenvorteil darstellt. Weiter ermöglicht das Schlüssellochprinzip die sog. "Einhand-Montage" und wird daher in manchen Fällen z.B. bei schwer zugänglichen Montagebereichen sehr gerne eingesetzt.

Bei der Montage kann sich das Bauteil im Schlüsselloch jedoch verdrehen, wenn keine entsprechende Verdrehsicherung vorgesehen ist. Wenn der Sensor sich bei der Montage verdreht, ist eine sichere Erfüllung der Funktion des Sensors nicht gewährleistet.

Aus der Druckschrift EP 1 532 372 ist ein Bauteil bekannt, das eine Verdrehsicherung für die Montage in einem schlüssellochförmigen Ausschnitt aufweist. Allerdings ist das Bauteil zunächst in das Schlüsselloch einzubringen und in dem Schlüsselloch festzuhalten, um die Verdrehsicherung wirksam werden zu lassen. Aus der DE 10 2005 002 021 A1 ist eine Befestigungsanordnung zur Befestigung eines Bauteils an einer Wand, insbesondere einer Dünnblechwand eines Kraftfahrzeugs bekannt, die eine Wand mit einer schlüssellochförmigen Öffnung aufweist, durch deren erster Abschnitt eine am Bauteil überstehend angeordnete Schraube mit Ihrem Schaumkopf hindurchführbar ist und deren zweiter Abschnitt randseitig den eingesetzten Schraubenkopf hinter greift, wobei am Bauteil ein Sicherungselement vorgesehen ist. Das Sicherungselement ist eine mit dem Bauteil verbundene elastische Feder, die mit einem Rastvorsprung im Bereich der Öffnung in der Wand zusammenwirkt.

Aus der WO 2004/020844 A1 ist eine Befestigungsanordnung bekannt, die das Schlüssellochprinzip nutzt. Dabei wird ein erstes Bauteil mit einer Schraube mit einem runden und glatten Kopf durch die größere Öffnung des Schlüssellochs hindurchgeführt, um dann mit dem Kopf die kleinere Öffnung des schlüssellochartigen Ausschnittes zur Befestigung zu hintergreifen. Die Schraube weist vorzugsweise an ihrem Ende des Schraubenschafts eine Außenverzahnung oder einen Außenvielkant als Angriffsfläche für ein Werkzeug zur Befestigung des ersten Bauteils an dem zweiten Bauteil auf. Das Dokument WO 2004/020844 A1 offenbart somit eine Befestigungsvorrichtung zur Befestigung eines Elementes in einem schlüssellochförmigen Ausschnitt einer Wand, wobei die Befestigungsvorrichtung folgende Merkmale aufweist: eine Halteplatte, die ausgebildet ist, um an einer Vorderseite der Wand anzuliegen und zumindest teilweise einen Rand einer schmäleren Öffnung des schlüsselförmigen Abschnitts einer Wand zu überdecken: und ein von der Halteplatte hervorstehendes winkeliges Stützelement, das ausgebildet ist, um Eingriff durch eine breitere Öffnung des schlüssellochförmigen Ausschnitts der Wand zu nehmen und um die Befestigungsvorrichtung bei der Befestigung gegen einen Rand der breiteren Öffnung abzustützen, wobei das Stützelement einen ersten Teilabschnitt aufweist, der im befestigten Zustand der Befestigungsvorrichtung eine Auflagekante zur Auflage an dem Rand der breiteren Öffnung in der Wand bildet, wobei das Stützelement ebenfalls einen zweiten Teilabschnitt aufweist, der im Wesentlichen rechtwinklig von dem ersten Teilabschnitt absteht.

### Offenbarung der Erfindung

Die vorliegende Erfindung schafft eine Befestigungsvorrichtung zur Befestigung eines Elementes in einem schlüssellochförmigen Ausschnitt einer Wand gemäß Anspruch 1. Ferner schafft die vorliegende Erfindung ein Verfahren zum Befestigen einer Befestigungsvorrichtung an einer Wand gemäß Anspruch 8. Die vorliegende Erfindung basiert auf der Erkenntnis, dass ein Verdrehen der Befestigungsvorrichtung beim befestigen dadurch verhindert werden kann, dass beim Einführen der Befestigungsvorrichtung das Stützelement in die breitere Öffnung des schlüssellochförmigen Ausschnitts in die Wand eingefügt wird und dieses Stützelement sich beim Befestigen der Befestigungsvorrichtung seitlich gegen einen Rand der breiteren Öffnung abstützt. Die Befestigungsvorrichtung kann sich dann beim Befestigen mittels beispielsweise einer Schraubvorrichtung im Bereich der schmäleren Öffnung nicht mehr Verdrehen. Auch kann die Befestigungsvorrichtung nicht mehr so einfach aus dem schlüssellochförmigen Ausschnitt herausfallen, da ein solches Herausfallen durch das (von dem Halteelement hervorstehende) Stützelement auch bei einer noch nicht erfolgten Befestigung zumindest teilweise verhindert wird. Dies erfolgt dadurch, dass sich bei einem Nach-vorne-Kippen der Befestigungsvorrichtung das Stützelement, das durch die breitere Öffnung Eingriff nimmt, am oberen Rand der breiteren Öffnung verkantet und somit ein vollständiges Herausfallen der Befestigungsvorrichtung aus dem schlüssellochförmigen Ausschnitt verhindert. Um eine möglichst große Auflagefläche zwischen Stützelement und dem seitlichen Rand der größeren Öffnung zu haben, kann insbesondere das Stützelement gerade Seitenkanten haben und günstigerweise auch der schlüssellochförmige Ausschnitt im Bereich der breiteren Öffnung gerade Seitenränder haben.

Die vorliegende Erfindung bietet den Vorteil, dass durch ein einfaches und kostengünstig zu implementierendes zusätzliches Element eine deutliche Verbesserung der Verdrehungssicherung ermöglicht wird. Insbesondere durch das Vorsehen der seitlichen Abstützung am Rand der breiteren Öffnung des schlüssellochförmigen Ausschnitts kann dadurch eine Verdrehungssicherung implementiert werden, die ausreichend belastbar gegen die Torsionskräfte beispielsweise beim Festschrauben der Befestigungsvorrichtung sind. Erfindungsgemäß weist das Stützelement eine gerade Auflagekante zur Auflage an dem seitlichen Rand der breiteren Öffnung auf. Auf diese Weise wird verhindert, dass die Abstützung nur punktförmig erfolgt, so dass eine hohe Materialbeanspruchung an diesem Punkt auftritt, der möglicherweise zu einem Materialverschleiß an diesem Auflagepunkt zwischen Stützelement und Seitenrand der Öffnung führt. Gemäß der Erfindung sind zumindest zwei Stützelemente vorgesehen, die ausgebildet sind, um die Befestigungsvorrichtung an gegenüberliegenden Rändern der breiteren Öffnung in der Wand abzustützen. Dies bietet eine einheitliche Verdrehungssicherung, wobei nicht auf eine mögliche Drehrichtung beim Festschrauben Rücksicht genommen werden muss. Die herzustellende Befestigungssicherung wird damit flexibler einsetzbar bei lediglich geringen konstruktiven Änderungen in der Form.

Auch können die beiden Stützelemente jeweils eine Stützkante aufweisen, welche in einem gegenseitigen Abstand angeordnet sind, der einer Breite der breiteren Öffnung des schlüssellochförmigen Ausschnitts in der Wand entspricht. Diese Ausführungsform der Erfindung bietet den Vorteil, dass durch die Stützelemente bereits eine gute Führung bzw. ein Festklemmen der Befestigungsvorrichtung in dem schlüssellochförmigen Ausschnitt gegeben ist, so dass ein Herausfallen der Befestigungsvorrichtung bereits weitgehend verhindert werden kann.

Ferner kann auch in einer anderen Ausführungsform der Erfindung das zumindest eine Stützelement eine winkelige Form aufweisen. Dies bietet eine Erhöhung der Stabilität, wodurch auch bei hohen Torsionskräften eine ausreichende Abstützung der Befestigungsvorrichtung am seitlichen Rand der breiteren Öffnung möglich wird, ohne eine Zerstörung des Stützelementes befürchten zu müssen.

Auch kann in einer weiteren Ausführungsform der Erfindung ein Teilabschnitt des winkligen Stützelementes im befestigten Zustand im Wesentlichen rechtwinklig von einem Rand der breiteren Öffnung in einen Innenbereich der breiteren Öffnung absteht, wobei der Teilabschnitt an derjenigen Seite des Stützelementes angeordnet ist, die der schmäleren Öffnung abgewandt ist. Diese Anordnung des winklig in den Innenbereich der breiteren Öffnung abstehenden Teilabschnitts bietet den Vorteil, dass hierdurch eine größtmögliche Stützkraft dieses Teilabschnitts des Stützelements möglich wird.

Ferner kann die Befestigungsvorrichtung ein Rastelement umfassen, das ausgebildet ist, um im befestigten Zustand der Befestigungsvorrichtung Eingriff durch eine breitere Öffnung des schlüssellochförmigen Ausschnitts der Wand zu nehmen und um die Befestigungsvorrichtung von einer Rückseite der Wand zu halten. Eine solche Ausführungsform der Erfindung bietet einen zusätzlichen Halt gegen ein Herausfallen der Befestigungsvorrichtung aus dem schlüssellochförmigen Ausschnitt in der Wand.

Auch kann das Rastelement einen Haken umfassen, der aus einem flexiblen Material gebildet ist. Dies biete die Möglichkeit einen einfach herzustellenden und sicher funktionierenden Schnappverschluss zur Halterung einsetzen zu können.

Auch kann das Rastelement in einer weiteren Ausführungsform der Erfindung von einem Schutzelement zumindest teilweise umgeben sein. Diese Ausführungsform der Erfindung bietet einen erhöhten Schutz für das Rastelement gegen eine Beschädigung.

Ferner kann gemäß einer weiteren Ausführungsform der Erfindung ein Sensorelement mit einer Befestigungsvorrichtung vorgesehen sein, wie sie vorstehend beschrieben wurde. Ein solches Sensorelement bietet den Vorteil, dass insbesondere ein sehr sicherer Verdrehungsschutz implementiert werden kann, so dass das Sensorelement bei der Befestigung hochgenau ausgerichtet bleibt.

### Kurze Beschreibung der Zeichnungen

Die Erfindung wird nachstehend anhand der beigefügten Figuren beispielhaft näher erläutert. Es zeigt:
- Fig. 1: eine perspektivische Darstellung eines ersten Ausführungsbeispiels der vorliegenden Erfindung;
- Fig. 2: eine Seitenansicht des ersten Ausführungsbeispiels der vorliegenden Erfindung im befestigten Zustand;
- Fig. 3: eine perspektivische Darstellung einer Ausführungsform einer Befestigungsvorrichtung mit einem Rastelement;
- Fig. 4: eine Seitenansicht der in Fig. 3 dargestellten Ausführungsform der Befestigungsvorrichtung;
- Fig. 5: eine Darstellung eines Ausschnitts der Seitenansicht aus Fig. 4, in dem das Einrastverhalten des Rastelementes vor und nach dem Einrasten dargestellt ist;
- Fig. 6: eine perspektivische Darstellung eines zweiten Ausführungsbeispiels der vorliegenden Erfindung;
- Fig. 7: eine Seitendarstellung des zweiten Ausführungsbeispiels der vorliegenden Erfindung bei der Befestigung;
- Fig. 8: ein Ablaufdiagramm eines Ausführungsbeispiels der vorliegenden Erfindung als Verfahren; und
- Fig. 9: eine Darstellung einer möglichen Form der schlüssellochförmigen Aussparung in der Wand bzw. dem Träger.

Eventuell angegebene Dimensionen und Maße sind nur exemplarisch, so dass die Erfindung nicht auf diese Dimensionen und Maße beschränkt ist. Gleiche oder ähnliche Elemente sind mit gleichen oder ähnlichen Bezugszeichen versehen. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden können oder sie zu weiteren, hier nicht explizit beschriebenen Kombinationen zusammengefasst werden können.

### Ausführungsformen der Erfindung

Ziel der Erfindung ist es unter anderem, einen erweiterten Verdrehschutz bei der Montage eines Bauteils mit Schlüssellochanschraubkonzept zu gewährleisten. Dabei soll ferner eine Möglichkeit geboten werden, dass das teilweise Herauskippen des Bauteils nach dem Steckvorgang eines Anschraubbolzens in das Schlüsselloch verhindert wird. Bei diesem Herauskippen kann es passieren, dass sich das Bauteil um die Bolzenachse eines Befestigungsbolzens dreht und anschließend nicht mehr korrekt angeschraubt werden kann. Diese Gefahr wird mit Hilfe der vorliegenden Erfindung beseitigt.

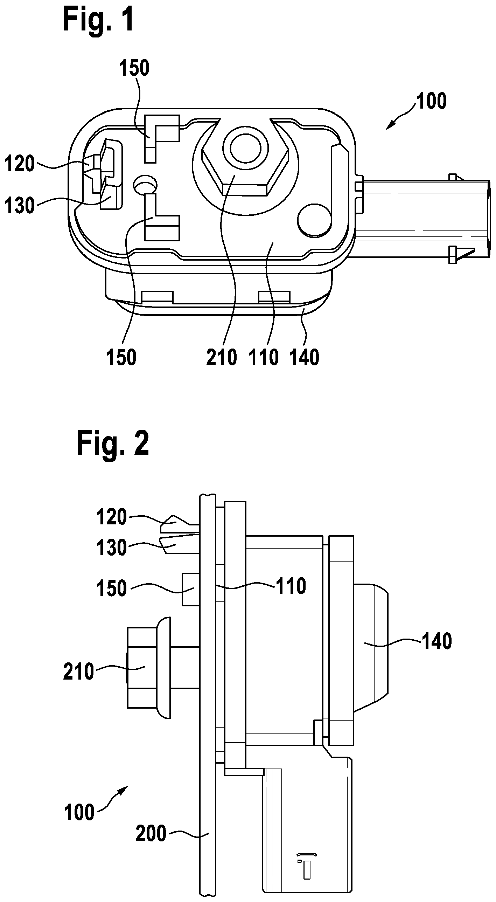

In Fig. 1 ist eine perspektivische Ansicht eines ersten Ausführungsbeispiels der vorliegenden Erfindung dargestellt. Ein Befestigungselement 100 umfasst ein Halteelement 110, das beispielsweise durch eine Halteplatte gebildet wird, die an einer Wand aufliegt, wenn die Befestigungsvorrichtung 100 in dem schlüssellochförmigen Ausschnitt in der Wand oder eines Trägers befestigt wird. Das Halteelement 110 sollte in diesem Fall einen Rand des schmäleren Abschnitts (Öffnung) des schlüssellochförmigen Ausschnitts bedecken, damit eine Abstützung des Halteelementes 110 sowohl an der Wand als auch eine Kontaktierungsmöglichkeit (beispielsweise eines Bolzens) durch das Halteelement 110 in den schmäleren Abschnitt des schlüsselförmigen Ausschnitts in der Wand möglich ist. Weiterhin umfasst die Befestigungsvorrichtung ein Rastelement 120, das beispielsweise in einem Clip-In-Pin mit Rastnase aus einem flexiblen Material besteht. Die Erfindung beruht im Wesentlichen auf einer Verrastung der Befestigungsvorrichtung 100 im "Schlüsselloch" während der Vormontage (d.h. dem Stecken der Befestigungsvorrichtung in das Schlüsselloch).

Weiterhin ist in dem in Figur 1 dargestellten Ausführungsbeispiel der vorliegenden Erfindung noch ein Schutzelement 130 vorgesehen, welches das Rastelement 120 U-förmig umgibt. Das Schutzelement 130 kann dabei eine Breite aufweisen, die der Breite der breiteren Öffnung des Schlüssellochs entspricht. Hierdurch kann sichergestellt werden, dass einerseits das Schutzelement 130 eine Beschädigung oder ein Abbrechen des Rastelements 120 vor dem Einbau der Befestigungsvorrichtung 100 verhindert und andererseits zugleich eine seitliche Verdrehung der Befestigungsvorrichtung 100 beim Befestigen verhindert wird. Das Schutzelement 130 kann so ausgelegt werden, dass die maximale Auslenkung bzw. Federweg des Rastelements 120 begrenzt wird, so dass beim Einbau das Rastelement 120 nicht beschädigt bzw. abbrechen kann. An der Befestigungsvorrichtung 200 kann ein Sensor 140 zur Messung von beispielsweise einer Beschleunigung angebracht sein, so dass durch die Sicherung gegen Verdrehungen, die durch die vorliegenden Erfindung bereitgestellt wird, eine hochgenaue Ausrichtung des Sensors vor der Befestigung an beispielsweise einer Karosseriewand eines Fahrzeugs möglich ist. Auf diese Weise kann die Ausrichtung auch beim Befestigen des Sensors (beispielsweise unter Verwendung einer Schraubvorrichtung) nicht verrutschen.

Erfindungsgemäß ist jedoch zumindest ein Stützelement 150 vorgesehen, das beim Befestigen der Befestigungsvorrichtung in der Wand oder einem Träger die Möglichkeit bietet, die Befestigungsvorrichtung gegen einen seitlichen Rand der breiteren Öffnung des schlüssellochförmigen Ausschnitts abzustützen. In dem in Fig. 1 dargestellten Ausführungsbeispiel sind zwei derartige Stützelemente 150 abgebildet, die beim Einfügen der Befestigungsvorrichtung in den schlüssellochförmigen Ausschnitt eingeführt werden. Durch die geschickte Wahl der Höhe der Stützelemente 150 oder des Mutterabstands zum Gehäuse wird erreicht, dass sich die Befestigungseinrichtung 100 nach dem Stecken ins Schlüsselloch auch nach Wiederherauskippen aus dem Schlüsselloch (vor dem Einrasten des Rastelements 120) nicht um die Achse des Schraubverbindung 210 verdrehen lässt, da das Ende der Stützelemente in die seitliche Wand des Schlüssellochs hineinragt. Auch nach dem Einrasten der Rasteinrichtung 120 bieten die seitlichen Stützen 150 bei der Endmontage einen Verdrehschutz der Befestigungsvorrichtung 100 in beide Drehrichtungen. Die Stützelemente sind dabei winklig ausgeführt, wobei Teilabschnitt jedes der Stützelemente 150 lotrecht zu einer Kante ausgeführt ist, an der eine Abstützung der Befestigungsvorrichtung am Seitenrand der breiteren Öffnung erfolgen soll. Dieser lotrechte Teilabschnitt ist an demjenigen Ende des im befestigten Zustand an der Abstützkante anliegenden Teils angeordnet, der der schmäleren Öffnung am Weitesten entfernt ist. Hierdurch kann ein größtmöglicher Halt des (meist aus Kunststoff gefertigten) Stützelementes sichergestellt werden, da durch die Hebelwirkung die Biegekräfte an einem am weitesten entfernten Punkt um die Drehachse leicht aufgenommen werden können. Aus diesem Grund ist eine Abstützung durch den zur Abstützkante lotrechten Teil dann am günstigsten, wenn dieser lotrechte Teil am weitesten von einer möglichen Drehachse entfernt ist, die im Bereich der schmäleren Öffnung anzusetzen ist.

Der Vorteil der Erfindung besteht in einer effizienten, kostengünstigen und einfach zu implementierenden Verdrehungssicherung und in der teilweisen Vermeidung eines Herauskippens nach dem Stecken der Befestigungsvorrichtung in das Schlüsselloch. Dadurch wird ein Fehlverbau durch Verdrehung des Bauteils nach der Vormontage und vor dem endgültigen Verschrauben wirksam verhindert.

Um eine Herstellung der Befestigungsvorrichtung 100 möglichst einfach und kostengünstig zu gestalten, kann das Halteelement 110, das Rastelement 120, das Schutzelement 130 sowie die Stützelemente 150 einstückig aus einem flexiblen Kunststoffmaterial hergestellt werden. Hierdurch ist lediglich eine einfache und kostengünstige Anpassung einer Spritzgussform erforderlich, um die Vorteile der Erfindung nutzen zu können. Der erforderliche Mehrverbrauch an Kunststoffmaterial ist vernachlässigbar.

In Figur 2 ist das in Figur 1 dargestellte Ausführungsbeispiel der vorliegenden Erfindung im verbauten Zustand an einer Wand 200 in einer Schnittdarstellung wiedergegeben. Hierbei ist auch die Schraubverbindung 210 dargestellt, welche mit dem Halteelement 110 zusammenwirkt und die Befestigungsvorrichtung 100 im Bereich des schmäleren Abschnitts des Schlüssellochs an der Wand 200 befestigt.

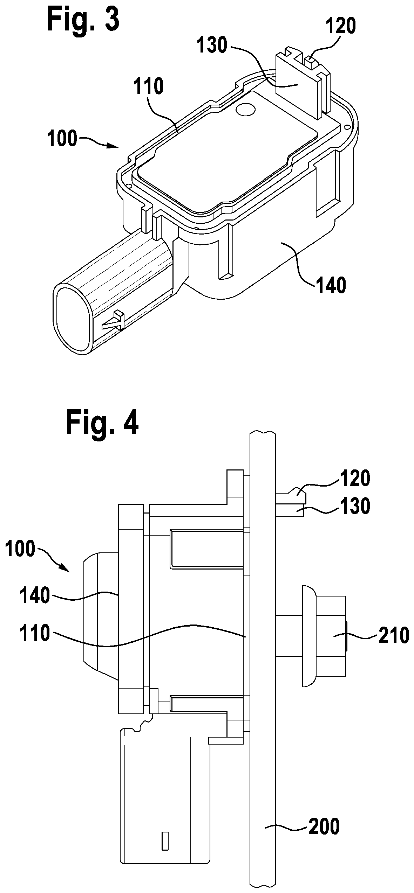

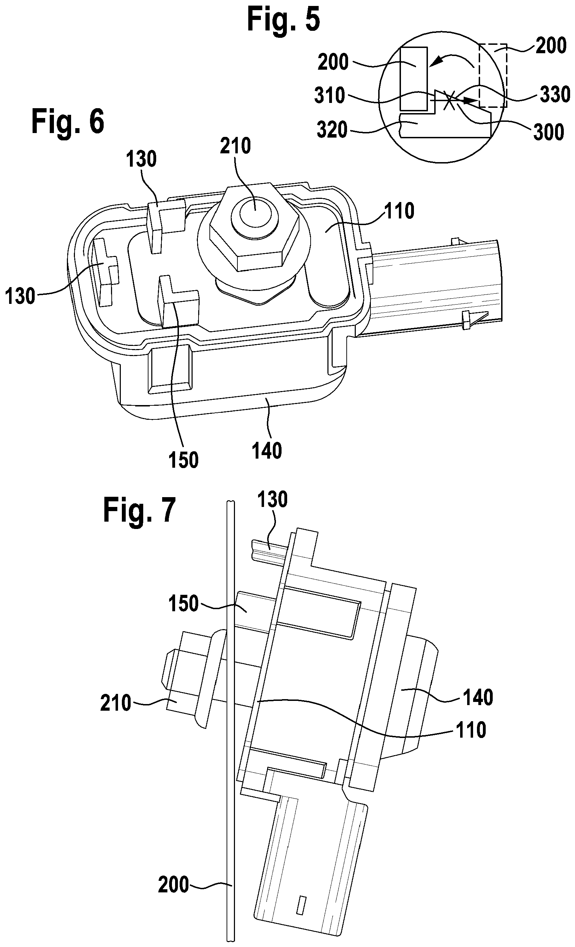

In Fig. 3 ist eine Ausführungsform näher dargestellt, bei der insbesondere ein Rastelement 120 mit einem Kunststoffschutzanker 130 abgebildet ist. Hierdurch kann ein effizientes Befestigen der Befestigungsvorrichtung 100 durch ein Vermeiden eines Herauskippens der Befestigungsvorrichtung 100 vor dem Festschrauben sichergestellt werden. In Fig. 4 ist die Befestigung einer solchen Befestigungsvorrichtung an einer Wand abgebildet. Das Wirkprinzip der Ausführungsform gemäß dem in den Figuren 3 und 4 dargestellten Ausführungsbeispiel ist in Fig. 5 genauer dargestellt, welche einen Ausschnitt der Schnittdarstellung aus Fig. 2 vor (gestrichelte Darstellung der Wand 200) und nach dem Einrasten des Rastelementes 120 in der Wand 200 wiedergibt. Der flexible Clip-In-Pin (d.h. das Rastelement 120) kann beim Eindrücken der Befestigungsvorrichtung 100 durch die Berührung mit der Wand 200 in Richtung des Anschraubbolzens der Schraubverbindung 210 ausgelenkt werden, so dass die in Richtung "Gehäuse" flach ansteigende Rastnase 300 am Ende des Pins durch die Anschraubplatte 200 gedrückt werden kann. Der Winkel zwischen der dem Sensor zugewandten Seite 310 der Rastnase 300 und einem Verbindungssteg 320 ist deutlich steiler (idealerweise 90°) als der Winkel der dem Sensor abgewandten Seite 330 der Rastnase 300 und dem Verbindungssteg 320, so dass es zu einer Verrastung kommt, sobald der höchste Punkt der Rastnase 300 durch die Anschraubplatte 200 hindurch gelangt ist (d.h. es kommt zu einem Rückfedern des Pins bzw. des Rastelementes). Damit ist der umgekehrte Weg des Rastelementes 120 aus dem Schlüsselloch heraus idealerweise nicht mehr möglich. Bei Anwendungen, die eine einfache zerstörungsfreie Demontage der Befestigungseinrichtung 200 erfordern, kann die Rastnase auch mit einer weniger steilen Seite 310 ausgeführt werden (kein rechter Winkel). In diesem Fall ist das Rastverhalten nicht ideal - dafür ist es aber möglich, die Rastnase 300 wieder aus dem Schlüsselloch herauszuziehen. Als (weitere) Verdrehsicherung und auch zum Schutz des Pins 120 ist um den Pin ein Kunststoffanker 130 ausgeformt. Der Kunststoffanker 130 kann den Pin 120 beim Herunterfallen vor evtl. Beschädigungen schützen. Dazu sollte der Kunststoffanker 130 länger als der Pin 120 (gleiche Höhe) ausgelegt werden, so dass beim Herunterfallen eines Sensors 140 der Clip-In-Pin 120 unberührt bleibt.

Die Ausführungsform der Figuren 1 bis 3 ist dergestalt, dass der Rasthaken 120 das Herausfallen des Ankers 130 aus dem Schlüsselloch idealerweise verhindert. Der Anker 130 verhindert zusätzlich, dass der Sensor 140 (bzw. eine am Sensor 140 angebrachte Befestigungsvorrichtung 100) sich beispielsweise gegen einen Türträger einer Fahrzeugkarosserie verdrehen kann. Ist die Halteverbindung zwischen Rastelement 120 und Wand 200 jedoch ausreichend stark, kann auch die Verdrehung der Befestigungsvorrichtung 100 gegen die Wand um eine Achse der Schraubverbindung 210 verhindert werden.

In Fig. 6 ist eine perspektivische Darstellung eines zweiten Ausführungsbeispiels der vorliegenden Erfindung wiedergegeben. Hierbei ist gegenüber dem ersten Ausführungsbeispiel, welches in den Figuren 1 und 2 gezeigt ist, auf das Rastelement 120 verzichtet worden. Im Wesentlichen besteht die Erfindung somit in dem Vorsehen von zumindest einem Stützelement 150, durch welches eine seitliche Abstützung der Befestigungsvorrichtung 100 gegen die seitliche Wand der breiteren Öffnung des schlüssellochförmigen Ausschnitts beim Befestigen der Befestigungsvorrichtung möglich wird. Der Kunststoffanker 130 kann dabei nicht als Schutz für ein Rastelement verwendet werden, sondern dient als Führung bei dem Einfügen der Befestigungsvorrichtung in den schlüssellochförmigen Ausschnitt.

Bei Nutzung der Erfindung ist der Verdrehschutz auch dann gegeben, wenn das Bauteil 140 nach der Vormontage wieder teilweise aus dem Schlüsselloch herauskippt. Mit einer Erweiterung der Erfindung kann auch noch das teilweise Herauskippen des Bauteils aus dem Schlüsselloch vor der Endmontage verhindet werden. Ohne die Verwendung der Erfindung kann es passieren, dass sich das Bauteil nach dem teilweisen Herauskippen aus dem Schlüsselloch um die Bolzenachse (einer Schraubvorrichtung 210) dreht und anschließend nicht korrekt angeschraubt wird.

Die Erfindung beruht somit im Wesentlichen auf seitlichen Halterungen 150, die eine Verdrehung direkt nach dem Einhängen des Bauteils in das Schlüsselloch verhindern. Die Erweiterung nutzt eine Verrastung des Bauteils im Schlüsselloch während der Vormontage (Stecken der Bauteilhalterung in das Schlüsselloch). Für die Verrastung kann z.B. ein Clip-In-Pin verwendet werden, welcher aus einem flexiblen Pin mit einer Rastnase besteht. Die Verrastung kann auch ohne die seitlichen Halterungen verwendet werden. In diesem Fall ist nur dann kein Verdrehschutz gegeben, wenn das Bauteil nicht eingerastet ist und dann teilweise aus dem Schlüsselloch herauskippt (Figur 3 und 4). Ebenso kann die Erfindung ohne die Rasteinrichtung (z.B. Clip-In-Pin) verwendet werden, wenn kein Schutz gegen das teilweise Herauskippen erforderlich ist (Figur 6 und 7). In diesem Fall wirkt lediglich der Verdrehschutz (wie in Figur 7 dargestellt). In den Figuren 1 und 2 ist die Kombination von Verdrehschutz (seitliche Stützelemente 150) und Herauskippschutz (Rasteinrichtung 120) dargestellt.

Vorteil der Erfindung ist das Verhindern der Bauteilverdrehmöglichkeit nach dem Stecken der Bauteilhalterung in das Schlüsselloch. Verwendet man die Rasteinrichtung, so ist auch das teilweise Herauskippen des Bauteils aus dem Schlüsselloch nicht mehr möglich.

Die Erfindung kann prinzipiell bei allen Bauteilen, die das Schlüssellochanschraubkonzept nutzen eingesetzt werden.

Die Verwendung des beschriebenen Ansatzes ist aktuell die einzige bekannte Möglichkeit, um die Verdrehsicherheit bei Verwendung des durch die AK-LV29 (Standardspezifikation) festgelegten Lochbildes sicher zu stellen.

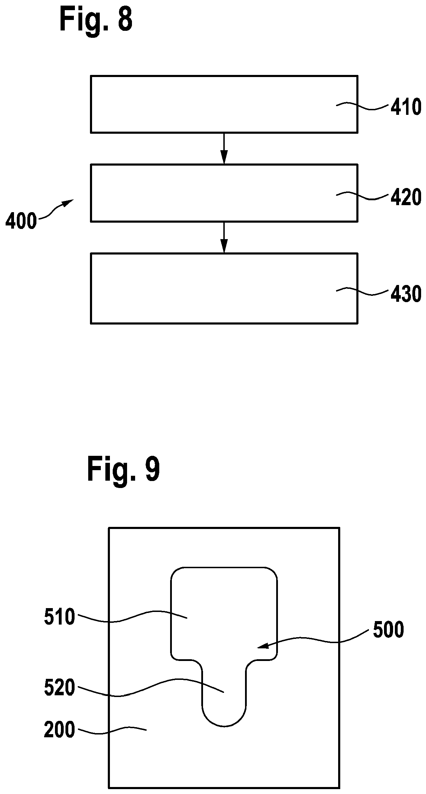

In Fig. 8 ist ein Ausführungsbeispiel der vorliegenden Erfindung als Verfahren 400 zum Befestigen einer Befestigungsvorrichtung an einer Wand, die einen schlüssellochförmigen Ausschnitt umfasst, dargestellt. Befestigungsvorrichtung weist ein Halteelement und ein Rastelement auf, wobei der schlüssellochförmige Ausschnitt durch eine breitere Öffnung in der Wand und eine mit der breiteren Öffnung verbundene schmälere Öffnung in der Wand gebildet ist. Das Verfahren umfasst einen ersten Schritt des Einführens 410 des Rastelementes der Befestigungsvorrichtung durch die breitere Öffnung des schlüssellochförmigen Ausschnitts der Wand wobei das Haltelemente einen Rand der schmäleren Öffnung des schlüssellochförmigen Ausschnitts zumindest teilweise überdeckt. Ferner umfasst das Verfahren 400 einen zweiten Schritt des Einrastens 420 des Rastelementes auf der Rückseite der Wand im Bereich der breiteren Öffnung des schlüssellochförmigen Ausschnitts und einen dritten Schritt des Andrückens 430 des Halteelementes an die Wand.

In Fig. 9 ist eine Darstellung einer Form einer schlüssellochförmigen Aussparung 500 in der Wand 200 oder einem Träger abgebildet. Hierbei sind die breitere 510 und die schmälere 520 Öffnung zu erkennen, wobei die schmälere Öffnung 520 im Wesentlichen von der Schraubvorrichtung 210 abgedeckt wird. Die breitere Öffnung 510 kann dabei eine eckige Form bzw. gerade Seitenränder aufweisen, um einen guten Halt des Stützelementes 150 in dem schlüssellochförmigen Ausschnitt 500 sicherzustellen. In der breiteren Öffnung 510 ist im montierten Zustand das Stützelement 150 zum Halten der Befestigungsvorrichtung 100 eingebracht.

## Patentansprüche

1. Befestigungsvorrichtung (100) zur Befestigung eines Elementes (140) in einem schlüssellochförmigen Ausschnitt (500) einer Wand (200), wobei die Befestigungsvorrichtung (100) folgende Merkmale aufweist:
- eine Halteplatte (110), die ausgebildet ist, um an einer Vorderseite der Wand (200) anzuliegen und zumindest teilweise einen Rand einer schmäleren Öffnung (520) des schlüsselförmigen Abschnitts (500) einer Wand (200) zu überdecken; und
- zumindest zwei von der Halteplatte (110) hervorstehende winkelige Stützelemente (150), die ausgebildet sind, um Eingriff durch eine breitere Öffnung (510) des schlüssellochförmigen Ausschnitts (500) der Wand (200) zu nehmen und um die Befestigungsvorrichtung (100) bei der Befestigung gegen gegenüberliegende seitliche Ränder (530) der breiteren Öffnung (510) abzustützen,
wobei die Stützelementes (150) jeweils einen ersten Teilabschnitt aufweisen, der im befestigten Zustand der Befestigungsvorrichtung (100) eine gerade Auflagekante zur Auflage an den jeweiligen seitlichen Rand (530) der breiteren Öffnung (510) in der Wand (200) bildet,
wobei die Stützelemente (150) ebenfalls jeweils einen zweiten Teilabschnitt aufweisen, der im Wesentlichen rechtwinklig von dem ersten Teilabschnitt absteht, wobei der zweite Teilabschnitt von der der im befestigten Zustand der Befestigungsvorrichtung (100) schmäleren Öffnung (520) abgewandten Seite des ersten Teilabschnitts absteht.

2. Befestigungsvorrichtung (100) gemäß Anspruch 1, **dadurch gekennzeichnet, dass** die beiden Stützelemente (150) jeweils eine Stützkante aufweisen, welche in einem gegenseitigen Abstand angeordnet sind, der einer Breite der breiteren Öffnung (510) des schlüssellochförmigen Ausschnitts (500) in der Wand (200) entspricht.

3. Befestigungsvorrichtung einem der vorangegangenen Ansprüche, **dadurch gekennzeichnet, dass** das winklige Stützelement (150) L-förmig ausgestaltet ist.

4. Befestigungsvorrichtung (100) gemäß einem der Ansprüche 1 bis 3, **dadurch gekennzeichnet, dass** sie ferner ein Rastelement (120) umfasst, das ausgebildet ist, um im befestigten Zustand der Befestigungsvorrichtung (100) Eingriff durch eine breitere Öffnung (510) des schlüssellochförmigen Ausschnitts (500) der Wand (200) zu nehmen und um die Befestigungsvorrichtung (100) von einer Rückseite der Wand (200) zu halten.

5. Befestigungsvorrichtung (100) gemäß Anspruch 4, **dadurch gekennzeichnet, dass** das Rastelement (120) einen Haken umfasst, der aus einem flexiblen Material gebildet ist.

6. Befestigungsvorrichtung (100) gemäß einem der Ansprüche 4 oder 5, **dadurch gekennzeichnet, dass** das Rastelement (120) von einem Schutzelement (130) zumindest teilweise umgeben ist.

7. Sensorelement (140) mit einer Befestigungsvorrichtung (100) gemäß einem der Ansprüche 1 bis 6.

8. Verfahren (400) zum Befestigen einer Befestigungsvorrichtung (100) an einer Wand (200), die einen schlüssellochförmigen Ausschnitt (500) umfasst, wobei die Befestigungsvorrichtung (100) eine Halteplatte (110) und zumindest zwei von der Halteplatte (110) hervorstehende winkelige Stützelemente (150) umfasst, wobei der schlüssellochförmige Ausschnitt (500) durch eine breitere Öffnung (510) in der Wand (200) und eine mit der breiteren Öffnung (510) verbundene schmälere Öffnung (520) in der Wand (200) gebildet ist, wobei die Stützelemente (150) jeweils einen ersten Teilabschnitt aufweisen, der im befestigten Zustand der Befestigungsvorrichtung (100) eine gerade Auflagekante zur Auflage an den jeweiligen seitlichen Rand (530) der breiteren Öffnung (510) in der Wand (200) bildet, wobei die Stützelemente (150) ebenfalls jeweils einen zweiten Teilabschnitt aufweisen, der im Wesentlichen rechtwinklig von dem ersten Teilabschnitt absteht, wobei der zweite Teilabschnitt von der der im befestigten Zustand der Befestigungsvorrichtung (100) schmäleren Öffnung (520) abgewandten Seite des ersten Teilabschnitts absteht und wobei das Verfahren (400) die folgenden Schritte umfasst:
- Einführen (410) der Stützelemente (150) der Befestigungsvorrichtung (100) durch die breitere Öffnung (510) des schlüssellochförmigen Ausschnitts (500) der Wand (200), wobei die Halteplatte (110) einen Rand der schmäleren Öffnung (520) des schlüssellochförmigen Ausschnitts (500) zumindest teilweise überdeckt;
- Stützen der Befestigungsvorrichtung (100) gegen eine Verdrehung durch Andrücken der jeweiligen Auflagekante der zwei Stützelemente (150) an den jeweiligen seitlichen Rand der breiteren Öffnung (510) des schlüssellochförmigen Ausschnitts (500); und
- Andrücken (430) der Halteplatte (110) an die Wand (200).

## Claims

1. Mounting device (100) for mounting an element (140) in a keyhole-shaped cutout (500) of a wall (200), wherein the mounting device (100) has the following features:
- a holding plate (110) which is designed to bear against a front side of the wall (200) and at least partially cover a rim of a narrower opening (520) of the keyhole-shaped cutout (500) of a wall (200); and
- at least two angle-shaped support elements (150) that stand proud of the holding plate (110) and are designed to engage in a broader opening (510) of the keyhole-shaped cutout (500) of the wall (200) and to brace the mounting device (100) against opposite lateral rims (530) of the broader opening (510) during mounting,
wherein the support elements (150) each have a first part section which, in the mounted state of the mounting device (100), forms a straight bearing edge for bearing against the respective lateral rim (530) of the broader opening (510) in the wall (200), wherein the support elements (150) also each have a second part section which projects essentially at right angles from the first part section, wherein the second part section projects from that side of the first part section which, in the mounted state of the mounting device (100), is oriented away from the narrower opening (520).

2. Mounting device (100) according to Claim 1, **characterized in that** the two support elements (150) each have a support edge, which are arranged at a mutual separation that corresponds to a breadth of the broader opening (510) of the keyhole-shaped cutout (500) in the wall (200).

3. Mounting device (100) according to either of the preceding claims, **characterized in that** the angle-shaped support element (150) is L-shaped.

4. Mounting device (100) according to one of Claims 1 to 3, **characterized in that** it also comprises a latching element (120) which is designed, in the mounted state of the mounting device (100), to engage through a broader opening (510) of the keyhole-shaped cutout (500) of the wall (200), in order to hold the mounting device (100) from a rear side of the wall (200).

5. Mounting device (100) according to Claim 4, **characterized in that** the latching element (120) comprises a hook which is made of a flexible material.

6. Mounting device (100) according to either of Claims 4 and 5, **characterized in that** the latching element (120) is at least partially surrounded by a protective element (130).

7. Sensor element (140) with a mounting device (100) according to one of Claims 1 to 6.

8. Method (400) for mounting a mounting device (100) to a wall (200) which comprises a keyhole-shaped cutout (500), wherein the mounting device (100) comprises a holding plate (110) and at least two angle-shaped support elements (150) that stand proud of the holding plate (110), wherein the keyhole-shaped cutout (500) consists of a broader opening (510) in the wall (200) and, connected to the broader opening (510), a narrower opening (520) in the wall (200), wherein the support elements (150) each have a first part section which, in the mounted state of the mounting device (100), forms a straight bearing edge for bearing against the respective lateral rim (530) of the broader opening (510) in the wall (200), wherein the support elements (150) also each have a second part section which projects essentially at right angles from the first part section, wherein the second part section projects from that side of the first part section which, in the mounted state of the mounting device (100), is oriented away from the narrower opening (520), and wherein the method (400) comprises the following steps:
- inserting (410) the support elements (150) of the mounting device (100) through the broader opening (510) of the keyhole-shaped cutout (500) of the wall (200), wherein the holding plate (110) at least partially covers a rim of the narrower opening (520) of the keyhole-shaped cutout (500);
- bracing the mounting device (100) against rotation by pressing the respective bearing edge of the two support elements (150) against the respective lateral rim of the broader opening (510) of the keyhole-shaped cutout (500); and
- pressing (430) the holding plate (110) against the wall (200).

## Revendications

1. Dispositif de fixation (100) pour la fixation d'un élément (140) dans un détouré (500) en forme de trou de serrure d'une paroi (200), le dispositif de fixation (100) présentant les caractéristiques suivantes :
- une plaque de maintien (110) réalisée pour buter contre un côté avant de la paroi (200) et pour recouvrir au moins en partie un bord d'une ouverture (520) plus étroite de la section (500) en forme de clé d'une paroi (200) ; et
- au moins deux éléments d'appui (150) en angle ressortant de la plaque de maintien (110) et réalisés pour entrer en prise à travers une ouverture (510) plus large du détouré (500) en forme de trou de serrure de la paroi (200) et pour soutenir le dispositif de fixation (100) lors de la fixation contre les bords (530) latéraux opposés de l'ouverture (510) plus large ;
les éléments d'appui (150) comportant respectivement une première section partielle formant à l'état fixé du dispositif de fixation (100) une arête portante droite à appuyer contre le bord (530) latéral respectif de l'ouverture (510) plus large dans la paroi (200), les éléments d'appui (150) comportant également respectivement une deuxième section partielle saillant pour l'essentiel à angle droit hors de la première section partielle, la deuxième section partielle saillant hors du côté de la première section partielle opposé à l'ouverture (520) la plus étroite à l'état fixé du dispositif de fixation (100).

2. Dispositif de fixation (100) selon la revendication 1, **caractérisé en ce que** les deux éléments d'appui (150) comportent respectivement une arête d'appui disposées à une certaine distance mutuelle correspondant à une largeur de l'ouverture (510) plus large du détouré (500) en forme de trou de serrure dans la paroi (200).

3. Dispositif de fixation selon l'une quelconque des revendications précédentes, **caractérisé en ce que** l'élément d'appui (150) en angle est réalisé en forme de L.

4. Dispositif de fixation (100) selon l'une quelconque des revendications 1 à 3, **caractérisé en ce qu'**il comprend en outre un élément d'arrêt (120) réalisé pour entrer en prise, à l'état fixé du dispositif de fixation (100), à travers une ouverture (510) plus large du détouré (500) en forme de trou de serrure de la paroi (200) et pour soutenir le dispositif de fixation (100) depuis un côté arrière de la paroi (200).

5. Dispositif de fixation (100) selon la revendication 4, **caractérisé en ce que** l'élément d'arrêt (120) comprend un crochet formé à partir d'un matériau flexible.

6. Dispositif de fixation (100) selon l'une quelconque des revendications 4 ou 5, **caractérisé en ce que** l'élément d'arrêt (120) est entouré au moins en partie par un élément de protection (130).

7. Élément de détection (140) avec un dispositif de fixation (100) selon l'une quelconque des revendications 1 à 6.

8. Procédé (400) pour la fixation d'un dispositif de fixation (100) à une paroi (200) comprenant un détouré (500) en forme de trou de serrure, le dispositif de fixation (100) comprenant une plaque de maintien (110) et au moins deux éléments d'appui (150) en angle saillant hors de la plaque de maintien (110), le détouré (500) en forme de trou de serrure étant formé par une ouverture (510) plus large dans la paroi (200) et une ouverture (520) plus étroite reliée à l'ouverture (510) plus large dans la paroi (200), les éléments d'appui (150) comportant respectivement une première section partielle formant, à l'état fixé du dispositif de fixation (100), une arête portante droite à appuyer contre le bord (530) latéral respectif de l'ouverture (510) plus large dans la paroi (200), les éléments d'appui (150) comportant également respectivement une deuxième section partielle saillant pour l'essentiel à angle droit hors de la première section partielle, la deuxième section partielle saillant hors du côté de la première section partielle opposé, à l'état fixé du dispositif de fixation (100), à l'ouverture (520) plus étroite et le procédé (400) comprenant les étapes suivantes :
- introduction (410) des éléments d'appui (150) du dispositif de fixation (100) à travers l'ouverture (510) plus large du détouré (500) en forme de trou de serrure de la paroi (200), la plaque de maintien (110) étant recouverte au moins en partie par un bord de l'ouverture (520) plus étroite du détouré (500) en forme de trou de serrure ;
- appui du dispositif de fixation (100) contre une rotation par compression de l'arête portante respective des deux éléments d'appui (150) contre le bord latéral respectif de l'ouverture (510) plus large du détouré (500) en forme de trou de serrure ; et
- compression (430) de la plaque de maintien (110) contre la paroi (200).
